# EUROPEAN PATENT APPLICATION

(11) **EP 3 258 523 A1**
(43) Date of publication of application: **20.12.2017**
(21) Application number: 16749243.8
(22) Date of filing: 09.02.2016
(51) Int. Cl.: H01M 8/0202, C22C 13/00, C22C 28/00, C22C 38/00, C22C 38/46, C22C 38/48, C22C 38/50, C23C 14/02, C23C 14/08, C23C 14/34, C23F 1/28, C23G 1/08, H01M 8/10

(54) **SEPARATOR FOR SOLID POLYMER FUEL CELL AND METHOD FOR PRODUCING SAME**

(30) Priority: 13.02.2015 JP 2015026422
(71) Applicant: Nippon Steel & Sumitomo Metal Corporation, Tokyo 100-8071 (JP)
(72) Inventor: TARUTANI, Yoshio, Tokyo 100-8071 (JP)
(74) Representative: J A Kemp
(86) International application number: PCT/JP2016/053844
(87) International publication number: WO 2016/129599

(57) **Abstract**

There is provided a separator for polymer electrolyte fuel cells having a substrate of a ferritic, having a chemical composition comprising, in mass %, C: 0.001 to 0.012%, Si: 0.01 to 0.6%, Mn: 0.01 to 0.6%, P: 0.035% or less, S: 0.01% or less, Cr: 22.5 to 35.0%, Mo: 0.01 to 4.5%, Ni: 0.01 to 2.5%, Cu: 0.01 to 0.6%, Sn: 0.01 to 1.0%, In: 0.001 to 0.30%, N: 0.015% or less, V: 0.01 to 0.35%, and Al: 0.001 to 0.050%, and the calculated value of {Content of Cr (%) + 3 × Content of Mo (%)} being 22.5 to 45.0, and includes a surface modified layer containing O: less than 30% and the balance: Sn and In. A polymer electrolyte fuel cell including the separator is remarkably excellent in corrosion resistance in an in-cell environment.

## Description

### TECHNICAL FIELD

The present invention relates to a separator for polymer electrolyte fuel cell and a method for producing the separator. The separator used herein is also referred to as a bipolar plate.

### BACKGROUND ART

Fuel cells are batteries that generate direct-current using hydrogen and oxygen, and are roughly classified into a solid-electrolyte type, molten carbonate type, phosphoric-acid type, and polymer-electrolyte type. These types are derived from the constituent material of an electrolyte portion that constitutes the essential part of each type of fuel cells.

Nowadays, fuel cells reaching their commercialized phase include a phosphoric-acid type, which operates at about 200°C, and a molten-carbonate type, which operates at about 650°C. With the progress of technical development in recent years, a polymer-electrolyte type, which operates at about a room temperature, and a solid-electrolyte type, which operates at 700°C or higher, come to be introduced on the market as a vehicle-mounted power source or a compact residential power source.

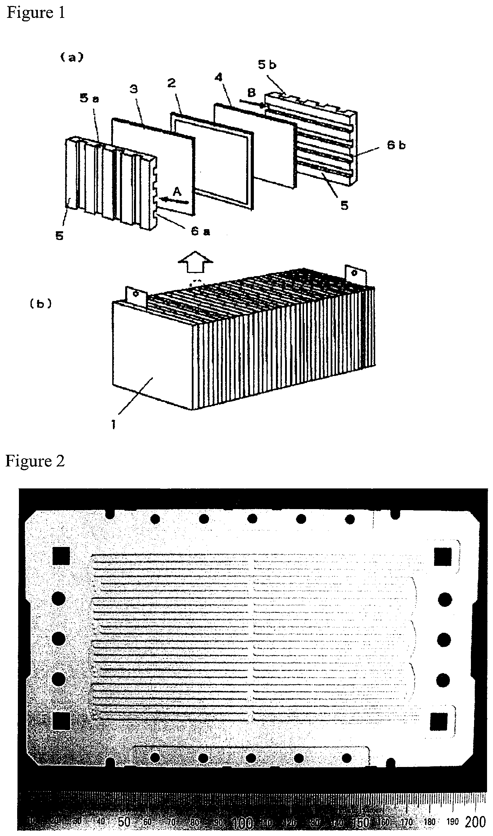

Figure 1 is a schematic diagram illustrating the structure of a polymer electrolyte fuel cell, where Figure 1(a) is a exploded view of the fuel cell (single cell), and Figure 1(b) is a perspective view of the entire fuel cell.

As illustrated in Figure 1(a) and Figure 1(b), a fuel cell 1 is an aggregation of single cells. A single cell has a structure in which, as illustrated in Figure 1(a), a fuel electrode layer (anode) 3 is located on one surface of a polymer electrolyte membrane 2, an oxidant electrode layer (cathode) 4 is located on the other surface of the polymer electrolyte membrane 2, separators 5a and 5b are located on both surfaces.

A typical polymer electrolyte membrane 2 is a fluorocarbon-type ion-exchange resin membrane that includes a hydrogen ion (proton) exchange group.

The fuel electrode layer 3 and the oxidant electrode layer 4 each include, on the surface of a diffusion layer that is made up of carbon paper or carbon cloth formed by carbon fiber, a catalyst layer that is made up of a particulate platinum catalyst, graphite powder, and a fluororesin including a hydrogen ion (proton) exchange group. The catalyst layer comes into contact with a fuel gas or an oxidative gas that passes through the diffusion layer.

Fuel gas (hydrogen or hydrogen-contained gas) A is caused to flow through channels 6a provided on the separator 5a, and hydrogen is supplied to the fuel electrode layer 3. In addition, oxidative gas B like air is caused to flow through channels 6b provided on the separator 5b, and oxygen is supplied. The supply of these gases causes electrochemical reaction, generating DC power.

The functions demanded of a polymer electrolyte fuel cell separator are: (1) a function as a "channel" that supplies the fuel gas on a fuel-electrode side uniformly across a surface; (2) a function as a" channel" that efficiently discharges water generated in the cathode side together with carrier gases such as air and oxygen after the reaction, from the fuel cell out of a system; (3) a function as a electric "connector" between single cells that keeps a low electric resistance and a good conductivity as an electrode for a long time; and (4) a function as a "partition wall" between an anode chamber of one of adjacent cells and a cathode chamber of the other cell.

Thus far, the application of a carbon plate material as a separator material has been intensively studied at a laboratory level. However, the carbon plate material involves a problem of being prone to be cracked and further involves a problem in that a machine working cost for flattening a surface and a machine working cost for forming the gas channels significantly increase. Both are major problems, and the situation is that the commercialization of fuel cells itself is difficult due to the problems.

Of all carbons, thermal expansive graphite processed goods are remarkably inexpensive and are attracting the most attention as a starting material for a polymer electrolyte fuel cell separator. However, dealing with an increasingly stringent dimensional accuracy, deterioration of a binding organic resin occurring with time in the application to the fuel cell, carbon corrosion that proceeds under an influence of fuel operation conditions, a hydrogen permeation problem called cross leakage, and an unexpected cracking accident in assembling and using the fuel cell are left as problems that should be solved in the future.

As a movement against such a study of the application of graphite-based starting materials, an attempt to apply a stainless steel to a separator has been started for cost reduction.

Patent Document 1 discloses a separator for fuel cells that is made up of a metallic member and includes a contact surface with an electrode of a unit battery is directly subjected to gold plating. As the metallic member, a stainless steel, aluminum, and a Ni-Fe alloy are listed, and as the stainless steel, SUS304 is used. According to the invention, since the separator is subjected to the gold plating, a contact resistance between the separator and the electrode is reduced, electronic continuity from the separator to the electrode becomes good, and thus the output voltage of the fuel cell increases.

Patent Document 2 discloses a polymer electrolyte fuel cell in which use is made of a separator made up of a metal material from which a passivation film to be formed on a surface is easily generated by the air. As the metal material, a stainless steel and a titanium alloy are listed. According to the invention, the passivation film is always present on the surface of the metal used for the separator, which makes the surface of the metal less prone to erosion chemically, decreases a degree of ionizing water generated in the fuel cell, and curbs the reduction of electrochemical reactivity in the fuel cell. In addition, by removing a passivation film from a portion of the separator that is in contact with an electrode layer and the like and forming a noble metal layer on the portion, an electric contact resistance value decreases.

However, even if use is made of a metal material such as the stainless steels disclosed in Patent Documents 1 and 2, each including a passivation film on its surface, for a separator as it is, the dissolution of metals occurs because corrosion resistance is insufficient, and the capability of a support catalyst deteriorates by dissolved metal ions. In addition corrosion products such as Cr-OH and Fe-OH generated after the dissolution increase the contact resistance of the separator, and thus the current situation is that a separator made up of a metal material is subjected to noble metal plating such as gold plating, without regard to cost.

In such circumstances, there has been proposed a stainless steel that is excellent in corrosion resistance and applicable as a separator in its pure state, without performing expensive surface treatment.

Patent Document 3 discloses a ferritic stainless steel for polymer-electrolyte fuel cell separators that contains no B (boron) in steel, causes none of M₂₃C₆, M₄C, M₂C, MC carbide-based metallic inclusions and M₂B metal boride to precipitate in steel as conductive metallic precipitates, and contains an amount of C 0.012% or less in steel (in the present specification, the unit symbol "%" in chemical composition means "mass%" unless otherwise noted). In addition, Patent Documents 4 and 5 disclose polymer electrolyte fuel cells each of which applies a ferritic stainless steel causing none of such conductive metallic precipitates to precipitate is applied as a separator.

Patent Document 6 discloses a ferritic stainless steel for separators of polymer electrolyte fuel cells that contains no B in steel but contains 0.01 to 0.15% of C (carbon) in steel, and causes only Cr carbides to precipitate, and discloses a polymer electrolyte fuel cell that applies the ferritic stainless steel.

Patent Document 7 discloses an austenitic stainless steel for separators of polymer electrolyte fuel cells that contains no B in steel but contains 0.015 to 0.2% of C in steel, contains 7 to 50% of Ni, and causes Cr carbides to precipitate.

Patent Document 8 discloses a stainless steel for separators of polymer electrolyte fuel cell in which one or more kinds of M₂₃C₆, M₄C, M₂C, and MC carbide-based metallic inclusions, and M₂B metal boride having conductivities are dispersed or exposed on a stainless steel surface, and discloses a ferritic stainless steel containing C: 0.15% or less, Si: 0.01 to 1.5%, Mn: 0.01 to 1.5%, P: 0.04% or less, S: 0.01% or less, Cr: 15 to 36%, Al: 0.001 to 6%, and N: 0.015% or less, wherein the contents of Cr, Mo, and B satisfy 17% ≤ Cr + 3 × Mo - 2.5 × B, and the balance consists of Fe and inevitable impurities.

Patent Document 9 discloses a method for producing a stainless steel material for separators of polymer electrolyte fuel cell in which the surface of a stainless steel product is corroded using an acid aqueous solution, and one or more kinds of M₂₃C₆, M₄C, M₂C, MC carbide-based metallic inclusions and M₂B metal boride having conductivities are exposed on the surface, and that contains C: 0.15% or less, Si: 0.01 to 1.5%, Mn: 0.01 to 1.5%, P: 0.04% or less, S: 0.01% or less, Cr: 15 to 36%, Al: 0.001 to 1%, B: 0 to 3.5%, N: 0.015% or less, Ni: 0 to 5%, Mo: 0 to 7%, Cu: 0 to 1%, Ti: 0 to 25 × (C% + N%), and Nb: 0 to 25 × (C% + N%), the contents of Cr, Mo, and B satisfy 17% ≤ Cr + 3 × Mo - 2.5 × B. Patent Document 9 also discloses a ferritic stainless steel material that includes the balance of Fe and impurities.

Patent Document 10 discloses a polymer electrolyte fuel cell in which M₂B metal borides are exposed on a surface, and assuming that the area of an anode and the area of a cathode are both one, an area in which the anode is in direct contact with a separator, and an area in which the cathode is in direct contact with the separator are both ratios from 0.3 to 0.7, and discloses a stainless steel in which one or more kinds of M₂₃C₆, M₄C, M₂C, MC carbide-based metallic inclusions and M₂B metal borides having conductivities are exposed on a surface of the stainless steel. Patent Document 10 further discloses a ferritic stainless steel material in which a stainless steel constituting a separator contains C: 0.15% or less, Si: 0.01 to 1.5%, Mn: 0.01 to 1.5%, P: 0.04% or less, S: 0.01% or less, Cr: 15 to 36%, Al: 0.2% or less, B: 3.5% or less (excluding 0%), N: 0.015% or less, Ni: 5% or less, Mo: 7% or less, W: 4% or less, V: 0.2% or less, Cu: 1% or less, Ti: 25 × (C% + N%) or less, Nb: 25 × (C% + N%) or less, and the contents of Cr, Mo, and B satisfy 17% ≤ Cr + 3 × Mo - 2.5 × B.

Furthermore, Patent Documents 11 to 15 disclose austenitic stainless clad steel materials in which M₂B boride conductive metallic precipitates are exposed on a surface, and methods for producing the austenitic stainless clad steel materials.

### LIST OF PRIOR ART DOCUMENTS

### PATENT DOCUMENT

Patent Document 1: JP10-228914A
Patent Document 2: JP8-180883A
Patent Document 3: JP3269479B
Patent Document 4: JP3097689B
Patent Document 5: JP3097690B
Patent Document 6: JP3397168B
Patent Document 7: JP3397169B
Patent Document 8: JP4078966B
Patent Document 9: JP3365385B
Patent Document 10: JP3888051B
Patent Document 11: JP3971267B
Patent Document 12: JP4155074B
Patent Document 13: JP4305031B
Patent Document 14: JP4613791B
Patent Document 15: JP5246023B

### SUMMARY OF INVENTION

### TECHNICAL PROBLEM

An objective of the present invention is to provide a separator for polymer electrolyte fuel cells that is remarkably excellent in corrosion resistance in an environment of a polymer electrolyte fuel cell and has a contact electric resistance the same as that of a gold-plated material, and to provide a method for producing the separator.

### SOLUTION TO PROBLEM

The present inventor has dedicated many years to develop stainless steel products that are hard to cause a decrease in catalyst capability and polymer film capability, the stainless steel products causing, even after a long-time use as a separator for polymer electrolyte fuel cells, extremely small metal dissolution from the surface of a metallic separator, and hardly allowing the progress of metal ion contamination of an MEA (the abbreviation of Membrane Electrode Assembly), which is constituted by a diffusion layer, a polymer film, and a catalyst layer.

Specifically, the present inventor has studied the application of conventional SUS304 and SUS316L, their gold-plating-treated materials, M₂B-conductive-metallic-precipitate-dispersed stainless materials or M₂₃C₆-conductive-metallic-precipitate-dispersed stainless materials, or conductive-particulate-powder-applying-treated materials or conductive-particulate-powder-coating-treated materials, to a fuel cell. As a result, the present inventor obtained the following findings (a) to (i) and accomplished the present invention.
(a) When a stainless steel product is subjected to spray etching using a ferrous chloride solution at 40° to 51° on the Baume scale and at a solution temperature of 30°C to 60°C, and is rinsed and subjected to drying treatment immediately thereafter, the surface of the stainless steel product is roughened into a favorable state as a separator for polymer electrolyte fuel cells. This provides the stainless steel product with excellent hydrophilicity and decreases the contact resistance value of the stainless steel product. It is the most preferable that the Baume degree of the ferrous chloride solution is 42 to 44°, and the solution temperature of the ferrous chloride solution is 32 to 37°C.
(b) When Sn and In are contained in steel, a metal Sn, a metal In, or their hydroxides and oxides are concentrated on the surface of the steel after pickling treatment, which improves the conductivity of the surface and decreases a contact resistance value with a fuel cell diffusion layer that is made up of carbon fiber. The effect of the improvement is stable for a long term.
(c) When a ferritic stainless steel material having a chemical composition defined in the present invention is subjected to spray etching using a ferrous chloride solution at a Baume degree of 40° to 51° and at a solution temperature of 30°C to 60°C, is rinsed and subjected to drying treatment immediately thereafter, and is further subjected to spray pickling treatment or acid solution immersion treatment using a sulfuric acid aqueous solution at a concentration of less than 20% and at a temperature from a normal temperature to 60°C, a smut that is principally made up of iron sulfates and contains Sn and In is adhered to the surface of the ferritic stainless steel material.
   The inside of a polymer electrolyte fuel cell is an acid environment by sulfuric acid, and the smut principally made up of iron sulfates and containing Sn and In resides on the surface in a relatively stable state for a long term. For this reason, the smut has conductivity and decreases a contact resistance value with a fuel cell diffusion layer that is made up of carbon fiber. The effect of improvement makes the performance of the fuel cell stable for a long term.
(d) When a ferritic stainless steel material having a chemical composition defined in the present invention is subjected to spray etching using a ferrous chloride solution at a Baume degree of 40° to 51° and at a solution temperature of 30°C to 60°C, is rinsed and subjected to drying treatment immediately thereafter, and is further subjected to spray pickling treatment or acid solution immersion treatment using a nitric acid aqueous solution at a concentration of less than 40% and at a temperature from a normal temperature to 80°C, a smut principally made up of iron that is formed in the ferrous chloride solution is dissolved, and a metal Sn and a metal In, and their hydroxides or oxides reside and are concentrated on the surface. For this reason, the smut has conductivity and decreases a contact resistance value with the fuel cell diffusion layer that is made up of carbon fiber. The effect of improvement makes the performance of the fuel cell stable for a long term.
(e) The availability of In on the market is low, and In is a very expensive metal. In is collected and recycled, but the addition of In as an alloying element by an amount necessary and sufficient to decrease the contact resistance to a desired level naturally has a limitation on its application to the mass production of separators for polymer electrolyte fuel cells that are needed in large quantity.
(f) An ITO (indium tin oxide) film formation technique applied to liquid crystal panels and the like has already been a complete technique. Thus, the formation of an extremely thin conductive coating film containing In and Sn on a metal surface by physical vapor deposition typified by the sputtering is effective as a mass-production technique of a polymer electrolyte fuel cell separator.
(g) Depositing a thick conductive coating film containing In and Sn by the physical vapor deposition, the amounts of In and Sn being necessary and sufficient to decrease the contact resistance value with the fuel cell diffusion layer made up of carbon fiber over a lifetime of one generation as a fuel cell separator, is not practical in terms of mass productivity. In particular, In and Sn have a behavior in which they are slowly dissolved under a condition in a fuel cell operation environment, and there is the risk that the performance rapidly degrades halfway.
(h) When Sn and In are contained as alloying elements in the vapor-deposited substrate described above, the physically vapor-deposited In and Sn on the outer layer are slowly dissolved depending on the fuel-cell operation conditions. At this point, the dissolution of a starting material also proceeds slowly, and the conductive coating film containing In and Sn is rebuilt and maintained on an outer-layer portion. This can remarkably enhance the durability of a polymer electrolyte fuel cell separator.
(i) By adding Mo (molybdenum) positively, a favorable corrosion resistance is secured. Mo has, even when dissolved, a relatively minor influence on the performance of a catalyst supported in anode and cathode parts. It is considered that this is because dissolved Mo is present in the form of a molybdate ion, which is an anion, and to have a small influence of hindering proton conductivity of a fluorocarbon-type ion-exchange resin membrane that includes a hydrogen ion (proton) exchange group. Similar behavior is expected from V (vanadium).

The present invention is as follows.
(1) A separator for polymer electrolyte fuel cells including
   a ferritic stainless steel, as a substrate, having a chemical composition including, in mass%:
   C: 0.001 to 0.012%;
   Si: 0.01 to 0.6%;
   Mn: 0.01 to 0.6%;
   P: 0.035% or less;
   S: 0.01% or less;
   Cr: 22.5 to 35.0%;
   Mo: 0.01 to 4.5%;
   Ni: 0.01 to 2.5%;
   Cu: 0.01 to 0.6%;
   Sn: 0.01 to 1.0%;
   In: 0.001 to 0.30%;
   N: 0.015% or less;
   V: 0.01 to 0.35%;
   Al: 0.001 to 0.050%;
   REM: 0 to 0.1%;
   Nb: 0 to 0.35%;
   Ti: 0 to 0.35%; and
   the balance: Fe and inevitable impurities, wherein
   a calculated value of {Content of Cr (mass%) + 3 × Content of Mo (mass%)} is 22.5 to 45.0 mass%, and further comprising
   a surface modified layer that has an oxygen concentration of less than 30 mass % and includes the balance containing Sn and In.
(2) A method for producing a separator for polymer electrolyte fuel cells, the method including
   forming, into a separator shape, a ferritic stainless sheet having a chemical composition including, in mass%:
   C: 0.001 to 0.012%;
   Si: 0.01 to 0.6%;
   Mn: 0.01 to 0.6%;
   P: 0.035% or less;
   S: 0.01% or less;
   Cr: 22.5 to 35%;
   Mo: 0.01 to 4.5%;
   Ni: 0.01 to 2.5%;
   Cu: 0.01 to 0.6%;
   Sn: 0.01 to 1.0%;
   In: 0.001 to 0.30%;
   N: 0.015% or less;
   V: 0.01 to 0.35%;
   Al: 0.001 to 0.050%;
   REM: 0 to 0.1%;
   Nb: 0 to 0.35%;
   Ti: 0 to 0.35%; and
   the balance: Fe and inevitable impurities, and
   a calculated value of {Content of Cr (mass%) + 3 × Content of Mo (mass%)} is 22.5 to 45.0 mass%,
   performing surface roughening by spray etching using a ferrous chloride solution at a Baume degree of 40° to 51° and a solution temperature of 30°C to 60°C,
   immediately thereafter, performing rinsing and drying, and
   thereafter, performing sputtering using an alloy, as a target, containing In and Sn at 95 mass% or more in total in a vacuum chamber a pressure of which is reduced to 10⁻³ mmHg or lower.
(3) A method for producing a separator for polymer electrolyte fuel cells, the method including
   forming, into a separator shape, a ferritic stainless sheet having a chemical composition including, in mass%:
   C: 0.001 to 0.012%;
   Si: 0.01 to 0.6%;
   Mn: 0.01 to 0.6%;
   P: 0.035% or less;
   S: 0.01% or less;
   Cr: 22.5 to 35.0%;
   Mo: 0.01 to 4.5%;
   Ni: 0.01 to 2.5%;
   Cu: 0.01 to 0.6%;
   Sn: 0.01 to 1.0%;
   In: 0.001 to 0.30%;
   N: 0.015% or less;
   V: 0.01 to 0.35%;
   Al: 0.001 to 0.050%;
   REM: 0 to 0.1%;
   Nb: 0 to 0.35%;
   Ti: 0 to 0.35%; and
   the balance: Fe and inevitable impurities, and
   a calculated value of {Content of Cr (mass%) + 3 × Content of Mo (mass%)} is 22.5 to 45.0 mass%,
   performing surface roughening by spray etching using a ferrous chloride solution at a Baume degree of 40° to 51° and a solution temperature from 30°C to 60°C,
   immediately thereafter, performing rinsing,
   thereafter, performing spray pickling treatment or acid solution immersion treatment using a sulfuric acid aqueous solution at a concentration of less than 20% and a temperature from a normal temperature to 60°C,
   immediately thereafter, performing rinsing and drying, and
   thereafter, performing sputtering using an alloy, as a target, containing In and Sn at 95 mass% or more in total in a vacuum chamber a pressure of which is reduced to 10⁻³ mmHg or lower.
(4) A method for producing a separator for polymer electrolyte fuel cells, the method including
   forming a ferritic stainless sheet having a chemical composition including, in mass%:
   C: 0.001 to 0.015%;
   Si: 0.01 to 0.6%;
   Mn: 0.01 to 0.6%;
   P: 0.035% or less;
   S: 0.01% or less;
   Cr: 22.5 to 35.0%;
   Mo: 0.01 to 4.5%;
   Ni: 0.01 to 2.5%;
   Cu: 0.01 to 0.6%;
   Sn: 0.01 to 1.0%;
   In: 0.001 to 0.30%;
   N: 0.015% or less;
   V: 0.01 to 0.35%;
   Al: 0.001 to 0.050%; and
   the balance: Fe and inevitable impurities, and
   a calculated value of {Content of Cr (mass%) + 3 × Content of Mo (mass%)} is 22.5 to 45.0 mass%, into a shape of a separator for polymer electrolyte fuel cells,
   performing surface roughening by spray etching using a ferrous chloride solution at a Baume degree of 40° to 51° and a solution temperature from 30°C to 60°C,
   immediately thereafter, performing rinsing,
   thereafter, performing spray pickling treatment or acid solution immersion treatment using a nitric acid aqueous solution at a concentration of less than 40% and a temperature from a normal temperature to 80°C,
   immediately thereafter, performing rinsing and drying, and
   thereafter, performing sputtering using an alloy, as a target, containing In and Sn at 95 mass% or more in total in a vacuum chamber a pressure of which is reduced to 10⁻³ mmHg or lower.
(5) The method for producing a separator for polymer electrolyte fuel cells according to any one of (2) to (4), further including,
   after the sputtering:
   performing spray pickling treatment or acid solution immersion treatment using a sulfuric acid aqueous solution at a concentration of less than 20% and a temperature from a normal temperature to 60°C; and
   immediately thereafter performing rinsing and drying treatment.
(6) The method for producing a separator for polymer electrolyte fuel cells according to any one of (2) to (4), further including,
   after the sputtering:
   performing spray pickling treatment or acid solution immersion treatment using a nitric acid aqueous solution at a concentration of less than 40% and a temperature from a normal temperature to 80°C; and
   immediately thereafter performing rinsing and drying treatment.
(7) The method for producing a separator for polymer electrolyte fuel cells according to any one of (2) to (6), wherein
   the chemical composition includes
   REM: 0.003 to 0.1%.
(8) The method for producing a separator for polymer electrolyte fuel cells according to any one of (2) to (7), wherein
   the chemical composition includes
   Nb: 0.001 to 0.35 mass% and/or
   Ti: 0.001 to 0.35 mass%, and
   satisfies 3.0 ≤ Nb / C ≤ 25.0, 3.0 ≤ Ti / (C + N) ≤ 25.0.

### ADVANTAGEOUS EFFECTS OF INVENTION

According to the present invention, it is possible to stably provide a polymer electrolyte fuel cell separator excellent in corrosion resistance and electric contact resistance performance, while dispensing with high cost surface treatment such as plating using expensive noble metal in order for the reduction of the contact resistance of a surface and reducing the usage of In, which is expensive and limited in its supply. The reduction of the cost of fuel-cell bodies, in particular, the cost of separators extremely matters to the full-fledged proliferation of polymer electrolyte fuel cells. It is expected that the present invention enables the full-fledged proliferation of metallic-separator-applied polymer electrolyte fuel cells.

### BRIEF DESCRIPTION OF DRAWINGS

[Figure 1] Figure 1 is a schematic diagram illustrating the structure of a polymer electrolyte fuel cell, where Figure 1(a) is a exploded view of the fuel cell (single cell), and Figure 1(b) is a perspective view of the entire fuel cell.
[Figure 2] Figure 2 is a picture showing the shape of a separator produced in Example 2.

### DESCRIPTION OF EMBODIMENTS

A mode for carrying out the present invention will be described in detail. Note that all of unit symbols "%" used in the followings represents mass %.

### 1. Chemical Composition of Separator for Polymer Electrolyte Fuel Cell

### (1-1) C: 0.001% or more and 0.012% or less

C (carbon) is an impurity existing in steel and allowed to be contained at up to 0.012%. Although it is possible, when the present refining technique is applied, to use the content of C less than 0.001%, it lengthens a refining time, leading to an increase in refining costs. Therefore, the content of C is set at 0.001% or more and 0.012% or less.

### (1-2) Si: 0.01% or more and 0.6% or less

Si (silicon) is contained at a range of 0.01% or more and 0.6% or less, for the purpose of deoxidation. A desirable lower limit of the content of Si is 0.15%, and a desirable upper limit of the content of Si is 0.45%. A content of Si less than 0.01% causes the additive amount of Al, necessary for deoxidation, to increase, which is unfavorable from the viewpoint of cost reduction. On the other hand, containing more than 0.6% of Si leads to degradation in sheet workability, resulting in a decrease in mass productivity of separators.

### (1-3) Mn: 0.01% or more and 0.6% or less

Mn (manganese) has the property of immobilizing S (sulfur) in steel in the form of Mn sulfides and has an effect of improving corrosion resistance. For this reason, the content of Mn is set at 0.01% or more. However, containing more than 0.6% of Mn exhibits no further effect of the improvement.

### (1-4) P: 0.035% or less

P (phosphorus), as well as S (sulfur), in steel is a most harmful impurity. Therefore, the content of P is set at 0.035% or less. The lower the content of P is, the more preferably it is.

### (1-5) S: 0.01% or less

S (sulfur), as well as P, in steel is a most harmful impurity. Therefore, the content of S is set at 0.01% or less. The lower the content of S is, the more preferable it is. Most of S precipitates in the form of Mn sulfides, Cr sulfides, Fe sulfides, or and composite nonmetallic precipitates with composite sulfides of these sulfides and composite oxides of these sulfides, depending on coexisting elements in steel and in proportion of the content of S in steel. In addition, S may form sulfides of REM that are added as necessary.

However, in the environment of a separator of a polymer electrolyte fuel cell, all nonmetallic precipitates having such compositions act as starting points of corrosion, while differing in degree, and thus are harmful to maintaining a passivation film and suppressing the dissolution of metal ions.

While the amount of S in steel in normal mass-produced steel is more than 0.005% and up to about 0.008%, the amount of S is preferably reduced to 0.004% or less to prevent the harmful influence described above. A more preferable amount of S in steel is 0.002% or less, and the most preferable level of the amount of S in steel is less than 0.001%. The lower the amount of S is, the more desirable it is.

With the present refining technique, making the amount of S less than 0.001% causes only a slight increase in producing costs even at an industrial mass-production level, and thus raises no problem in industrial production.

### (1-6) Cr: 22.5% or more and 35.0% or less

Cr (chromium) is a basic alloying element extremely important to secure the corrosion resistance of a base metal. The higher the content of Cr, the more excellent the resultant corrosion resistance is. In a ferritic stainless steel, a content of Cr more than 35.0% makes the production on a mass-production scale difficult. On the other hand, a content of Cr less than 22.5% makes a failure to secure a corrosion resistance necessary for a polymer electrolyte fuel cell separator even with the contents of the other elements changed.

### (1-7) Mo: 0.01% or more and 4.5% or less

Mo (molybdenum) has an effect of improving the corrosion resistance with a small quantity in comparison with Cr. Therefore, Mo is contained at 0.01% or more. Containing Mo more than 4.5% results in a poor sheet formability. For this reason, the upper limit of the content of Mo is set at 4.5%. In addition, Mo has the property of having a relatively minor influence on the performance of an MEA if Mo in steel is dissolved due to corrosion occurring inside the polymer electrolyte fuel cell. The reason for this property is that Mo is present not in the form of a metal cation but in the form of molybdate ions, which are anions, so that Mo has a little influence on the cation conductivity of a fluorocarbon-type ion-exchange resin membrane with a hydrogen ion (proton) exchange group.

### (1-8) Ni: 0.01% or more and 2.5% or less

Ni has an effect of improving the corrosion resistance and toughness. The upper limit of the content of Ni is set at 2.5%. A content of Ni more than 2.5% results in a poor sheet formability. The lower limit of the content of Ni is set at 0.01%. The lower limit of the content of Ni is the amount of the impurity that is mixed when the steel is industrially produced.

### (1-9) Cu: 0.01 to 0.6%

Cu (copper) is an impurity that is mixed when the steel is produced in volume, and is not added positively. The lower limit of the content of Cu is set at 0.01% or more, and the upper limit of the content of Cu is set at 0.6% or less. In the stainless steel according to the present invention, Cu exists in a dissolved state. When a Cu precipitates, it acts as a starting point of corrosion (starting point of dissolution) in the cell, reducing in fuel cell performance.

### (1-10) Sn: 0.01% or more and 1.0% or less

Sn (tin) is an extremely important addition element. Sn is contained in steel in a range of 0.01% or more and 1.0% or less. In the polymer electrolyte fuel cell, Sn is concentrated on the surface of the separator in the form of a metal Sn or Sn oxides, so as to reduce the surface contact resistance of the separator, and stabilize and improve the electric contact resistance performance of the separator as high as that of a gold-plated starting material. Sn also has an effect of inhibiting the dissolution of metal ions from the parent phase of the separator.

When the content of Sn is less than 0.01%, such an effect cannot be obtained, and when the content of Sn is more than 1.0%, the mass productivity decreases. For this reason, when Sn is contained, the content of Sn is set at 0.01% or more and 1.0% or less. The most desirable range of the content of Sn is 0.25% or more and 1.0% or less.

In the present invention, to apply the separator to a polymer electrolyte fuel cell, the separator is provided, on its outer layer, with a surface modified layer containing Sn by sputtering. Sn in steel prevents the surface modified layer on the outer layer from altering in fuel cell operation to decrease the performance of the separator.

### (1-11) In: 0.001% or more and 0.30% or less

In (indium) is an extremely important addition element. In is contained in steel in a range of 0.001% or more and 0.30% or less. In the polymer electrolyte fuel cell, In is concentrated on the surface of the separator in the form of a metal In or In oxides, so as to reduce the surface contact resistance of the separator, and stabilize and improves the electric contact resistance performance of the separator as high as that of a gold-plated starting material.

In the case of containing Sn in steel, the effect of improving the contact resistance performance is recognized with a small amount of In in comparison with the case of containing In alone. In also has an effect of inhibiting the dissolution of metal ions from the parent phase of the separator. When the content of In is less than 0.001%, such an effect cannot be obtained. In is an expensive rare metal. Thus, the smaller the additive amount is, the more preferable it is. When In coexists with Sn, the concentration of In on the surface of the separator is promoted, which allows a smaller amount of In to effectively provide the effect of improving the contact resistance improvement. The upper limit of the content of In is set at 0.30% or less. A preferable lower limit of the content of In is 0.05%, and a preferable upper limit of the content of In is 0.25%.

In the present invention, to apply the separator to a polymer electrolyte fuel cell, the separator is provided, on its outer layer, with a surface modified layer containing In by sputtering. In in steel prevents the surface modified layer on the outer layer from altering in fuel cell operation to decrease the performance of the separator.

### (1-12) N: 0.015% or less

In a ferritic stainless steel, N (nitrogen) is an impurity. N deteriorates the normal temperature toughness of the ferritic stainless steel, and thus the upper limit of the content of N is set at 0.015%. The lower the content of N is, the more desirable it is. Industrially, it is the most desirable to set the content of N at 0.007% or less. However, an excessive reduction of the content of N leads to an increase in melting costs. Thus, the content of N is desirably set at 0.001% or more.

### (1-13) V: 0.01% or more and 0.35% or less

V (vanadium) is not an element to be intentionally added but is inevitably contained in a Cr source that is added as a melted raw material in mass production. The content of V is set at 0.01% or more and 0.35% or less. V has an effect of improving the normal temperature toughness, although the effect is slim.

### (1-14) Al: 0.001% or more and 0.050% or less

Al (aluminum) is an element to be added for deoxidation and is added in a steel melting stage. The content of Al is set at 0.001% or more and 0.050% or less.

### (1-15) REM: 0.1% or less

REM(Rare earth metal(s)) are optional addition elements and are added in the form of a misch metal. The REM have an effect of improving hot productivity. For this reason, the REM may be contained at up to 0.1% as the upper limit of the content of the REM.

### (1-16) Calculated value of {Content of Cr (%) + 3 × Content of Mo (%)}: 22.5% or more and 45.0% or less

This value is an index that indicates, as a guide, the corrosion resistant behavior of a ferritic stainless steel in the present invention. This value is set at 22.5% or more and 45.0% or less. When this value is less than 22.5%, the corrosion resistance in the polymer electrolyte fuel cell cannot be secured sufficiently, causing the amount of metal ion dissolution to increase. On the other hand, when this value is more than 45.0%, the mass productivity significantly deteriorates.

### (1-17) Nb: 0.35% or less and/or Ti: 0.35% or less, and 3 ≤ Nb / C ≤ 25, 3 ≤ Ti / (C + N) ≤ 25

Ti (titanium) and Nb (niobium) are both optional addition elements and are elements that stabilize C and N in steel. Ti and Nb form their carbides and nitrides in steel. For this reason, both of Ti and Nb are contained, as necessary, at 0.35% or less, desirably 0.001% or more and 0.35% or less. Nb is contained so that the value of (Nb / C) becomes 3 or more and 25 or less, and Ti is contained so that the value of {Ti / (C + N)} becomes 3 or more and 25 or less.

Besides the above elements, the balance consists of Fe and inevitable impurities.

### 2. Surface Modified Layer of Separator for Polymer Electrolyte Fuel Cell

### (2-1) Metal Sn and Its Oxides

Sn is contained in a range of 0.01 to 1.0% as an alloying element in the steel melting stage. Sn is uniformly solid-solved in steel. At a content of Sn less than 0.01%, a desired effect of improving the contact resistance performance is not recognized, and containing more than 1.0% of Sn results in a poor mass productivity.

To apply the separator to a polymer electrolyte fuel cell, before surface modification treatment, the surface of a ferritic stainless sheet used in the present invention is roughened by spray etching using a ferrous chloride solution, immediately thereafter rinsed and dried, and as necessary, subjected to spray pickling or acid solution immersion treatment using a sulfuric acid aqueous solution at a concentration of less than 20% or a nitric acid aqueous solution at a concentration of less than 40%.

At this point, Sn that is solid-solved in steel is concentrated in the outer layer in the form of a metal Sn or concentrated on the surface in the form of its hydroxides or oxides (hereinafter, will be collectively referred to as "Sn oxides"), through starting material dissolution (corrosion) by the pickling.

Furthermore, immediately after the start of using the separator as a polymer electrolyte fuel cell separator, very slow dissolution of metals from the surface of the starting material proceeds in accordance with an in-fuel-cell environment, which causes a passivation film of the separator to alter. In the process, Sn displays a behavior in which Sn in steel is further concentrated on the surface in the form of Sn oxides along with the dissolution of the starting material, which gives rise to a state of the surface that is suitable to secure desired properties.

In addition, depending on fuel-cell operation conditions, very slow dissolution of metals from the surface of the starting material newly proceeds in accordance with changes in the in-fuel-cell environment, where Sn displays a behavior in which Sn in steel is further concentrated on the surface in the form of Sn oxides along with the dissolution, which gives rise to a state of the surface that is suitable to secure desired properties.

In addition, depending on the fuel-cell operation conditions, the Sn oxides concentrated on the outer layer may be very slowly dissolved in accordance with changes in the in-fuel-cell environment. The dissolved Sn oxides function so that Sn in steel is concentrated in the form of Sn oxides to rebuild the state of the surface suitable to secure the desired properties along with the dissolution of the starting material in the process of the alternation of the passivation film on the surface of the starting material that proceeds in accordance with changes in the in-fuel-cell environment after the dissolution of the concentrated Sn oxides. In the present invention, the outer layer is subjected to film formation treatment by sputtering to form a surface modified layer containing Sn. The surface modified layer promotes the concentration of Sn in the form of Sn oxides.

Of the performances improved by the effects of Sn, the surface contact resistance performance is enhanced to a great extent by the coexistence of In with Sn.

### (2-2) Metal In and Its Oxides

In is positively contained at a content within a range of 0.001 to 0.30% as an alloying element in the steel melting stage. When In is added in steel in the presence of Sn, In displays a behavior substantially the same as that of Sn, being concentrated on the surface of the starting material in the form of a metal In, or its hydroxides or oxides (hereinafter, will be collectively referred to as "In oxides").

The In oxides have the property of being excellent in conductivity in comparison with the Sn oxides and have a further contact resistance effect of improvement in comparison with the case where only the Sn oxides are present. Although the In oxides alone have the effect of improvement, the coexistence with the Sn oxides is very effective in causing the concentration of the In oxides on the surface.

In is a rare metal that is produced only in a limited number of countries, and its supply is limited even on a worldwide basis. The amount of In distributed on the market is also small, which makes In one of very expensive metals. While In is collected and recycled, the situation is that it is difficult to add a large quantity of In, as an alloying element, to a starting material for a polymer electrolyte fuel cell separator that is expected to have a great demand, and it is difficult to produce the starting material with the large quantity of added In, in volume production. The present invention presents measures to deal with the situation.

### 3. Method for Producing Separator for Polymer Electrolyte Fuel Cell

### (3-1) Sputtering Treatment

Physical vapor deposition under a reduced pressure is still low in production efficiency as industrial production means, remaining relatively high-cost industrial production means. This is one of the reasons that the physical vapor deposition has fallen short of its large scale application to stainless steel products whereas being widely studied as a surface treatment technique for stainless steel. In the present invention, as measures for reducing the amount of usage of In, which is expensive and under constraint on its amount of supply, the sputtering method is applied for the surface modification treatment. In other words, a method applying vapor deposition, which is a surface treatment method only for the outer layer, is employed rather than the addition of In in steel as the alloying elements in a large quantity necessary to obtain desired performance.

In the present invention, a conductive film being principally made up of In and Sn, typified by an ITO film widely used for liquid crystal displays and the like, is formed on the outer layer by the sputtering. Many of commercially available target materials for ITO film sputtering have a Sn-oxides ratio of about 10%. Target materials having a Sn-oxides ratio of 20 to 80% are also available. In the present invention, unlike the case of applying a conductive film to liquid crystal displays, the performance effect of improvement of the separator for polymer electrolyte fuel cells is recognized even in an increased proportion of Sn oxides in a sputtering target.

In addition, surface modification treatment may be performed the sputtering of which uses an alloy of a metal In and a metal Sn as a target rather than In oxides and Sn oxides.

The sputtering may be performed as starting material is in a coil shape. However, this raises problems such as flawing in a midstream step before the starting material is assembled as a separator for polymer electrolyte fuel cells, measures against the detachment of the starting material, and difficulty in performance assurance. It is the most preferable to apply the surface modification treatment in a final step after the starting material is formed as a polymer electrolyte fuel cell separator, and the surface roughness of the starting material is adjusted using an acid solution.

As the conditions for the sputtering, no special schemes or conditions are needed. Use may be made of the high power impulse magnetron sputtering (HiPIMS), which has made remarkable progress in recent years.

The sputtering is performed in a single-sheet manner; separators are treated one by one, although such single-sheet processing may be performed while a plurality of separators are fixed in a set of holders that allows a large number of separators to be fixed. Specifically, using the set of holders, a large number of separators are loaded into a pressure reducing chamber at a time, each holder is thereafter semi-continuously carried from the pressure reducing chamber to a sputtering chamber in the single-sheet manner, the surface modification treatment is performed, and after the surface modification treatment is completed, each holder is carried out from the sputtering chamber to a pressure recovering chamber in the single-sheet manner, and as being fixed in the set of holders, the large number of separators are carried out from the pressure recovering chamber at a time. This manner is the most excellent in mass productivity. Of course, the sputtering need not be performed in this manner as long as a desired surface modified layer, being principally made up of In and Sn, is formed on the outer layer.

The In-Sn-containing surface modified layer formed on the surface varies in adhesiveness and oxygen concentration depending on a degree of vacuum in a vacuum chamber and an amount of adsorbed water on the surface of the starting material carried in, as well as a substrate temperature in the sputtering. However, in the present invention, the oxygen concentration has a minor influence as long as the adhesiveness is secured. When the separator is applied as a polymer electrolyte fuel cell separator, the surface modified layer alters to be in a favorable state in accordance with the in-cell environment in operation regardless of the oxygen concentration in the film formed by the sputtering.

### (3-2) Spray Etching using Ferrous Chloride Solution

A ferrous chloride solution is widely used as an etchant of stainless steels also in the industrial field. In many cases, etching is performed on a masked metallic starting material, so as to locally reduce thickness or create through-holes. However, in the present invention, the etching is employed as treatment for roughening the surface of the separator and as a treatment method for concentrating Sn and In in the surface of the separator.

The ferrous chloride solution to be used is an aqueous solution at a very high concentration. The concentration of the ferrous chloride solution is determined on the Baume scale, which is determined in the form of a reading measured by a Baume's hydrometer. Although it is possible to perform the etching by immersing a separator in ferrous chloride solution in a settled state or by immersing a separator in flowing ferrous chloride solution, the most preferable treatment method in the present invention is to perform spray etching to roughen the surface. This is because the spray etching makes it remarkably easy to control a depth of etching, an etching rate, and a degree of roughening the surface with high efficiency and high precision, in production on an industrial scale.

Spray etching can be controlled by the ejection pressure of a nozzle, the amount of solution, the flow rate (linear flow rate) of solution on the surface of an etching starting material, the hitting angle of spray, and the temperature of solution. In water cleaning and drying treatment performed after the treatment, Sn and In come to be concentrated on the outer layer in the form of a metal Sn and a metal In, or in the form of Sn oxides and In oxides.

### (3-3) Spray Cleaning and Immersion Treatment using Sulfuric Acid Aqueous Solution

Spray cleaning and immersion treatment using a sulfuric acid aqueous solution have an effect of increasing the amounts of a metal Sn, a metal In, Sn oxides, and In oxides concentrated on the surface. The ferrous chloride solution used in the previous step is very low in pH and high in flow velocity, so that Sn and In are rather in the state that makes them difficult to be concentrated on the surface.

The spray cleaning and immersion treatment in the present invention, which uses a sulfuric acid aqueous solution at less than 20%, is performed in the state where a solution flow rate is lower than the solution flow rate (linear flow rate) on the surface of the etching starting material in the spray cleaning using the ferrous chloride solution, or performed in the state where the sulfuric acid aqueous solution is nearly settled. This is because such states further promote the concentration of Sn oxides and In oxides on the surface. In the water cleaning and drying treatment performed after the treatment, Sn and In are concentrated on the outer layer in the form of a metal Sn and a metal In, or in the form of Sn oxides and In oxides, forming a stabile outer-layer coating film.

### (3-4) Spray Cleaning and Immersion Treatment using Nitric Acid Aqueous Solution

Spray cleaning and immersion treatment using a nitric acid aqueous solution have an effect of increasing the amounts of a metal Sn, a metal In, Sn oxides, and In oxides concentrated on the surface. Since the ferrous chloride solution used in the previous step is very low in pH and high in flow velocity, Sn and In are rather in the state that makes them difficult to be concentrated on the surface.

The spray cleaning and immersion treatment in the present invention, which uses a nitric acid aqueous solution at less than 40%, is performed in the state where a solution flow rate is lower than the solution flow rate (linear flow rate) on the surface of the etching starting material in the spray cleaning using the ferrous chloride solution, or performed in the state where the sulfuric acid aqueous solution is nearly settled. This is because such states further promote the concentration of Sn oxides and In oxides on the surface. In the water cleaning and drying treatment performed after the treatment, Sn and In are concentrated on the outer layer in the form of a metal Sn and a metal In, or in the form of Sn oxides and In oxides, forming a stabile outer-layer coating film.

As for the surface modified layer principally made up of In and Sn that is formed on the surface through the surface modification by the sputtering, the concentration of O (oxygen) in the surface modified layer subjected to the sputtering varies depending on a moisture concentration and an oxygen concentration in a treatment bath in the surface modification, but is desirably low. An oxygen concentration in the surface modified layer of more than 30% results in decreases in adhesiveness and ductility of the surface modified layer made up of In and Sn. In addition, such an oxygen concentration is prone to decrease a sacrificial protection effect that the surface modified layer possesses for a ferritic stainless steel being the substrate when the surface modified layer is in a wet state in a polymer electrolyte fuel cell. The upper limit of the concentration of O in the surface modified layer is set at 30%. After the surface modification treatment, the spray treatment and acid immersion treatment are performed using a sulfuric acid aqueous solution or a nitric acid aqueous solution as necessary. In this case, sulfuric acid compounds or nitric acid compounds of In and Sn may be present on an outermost layer. None of the compounds raises problems on performance.

### (3-5) Ferrous Chloride Solution

The ferrous chloride solution is desirably low in the concentration of Cu ion and the concentration of Ni (nickel) ion in the solution, and there is no problem with using a ferrous chloride solution product for industrial use normally available in Japan. The concentration of the ferrous chloride solution used in the present invention is a solution at 40 to 51° on the Baume scale.

A concentration of the ferrous chloride solution less than 40° accelerates perforation corrosion tendency, which is unsuitable for roughening the surface. On the other hand, a concentration of the ferrous chloride solution more than 51° makes the etching rate remarkably low and also makes the deterioration rate of the solution high. For this reason, such a concentration is unsuitable for a treatment liquid for roughening the surface of a polymer electrolyte fuel cell separator necessary to be produced in volume.

In the present invention, the concentration of the ferrous chloride solution is set at 40 to 51° on the Baume scale, and a particularly preferable concentration of the ferrous chloride solution is 42 to 46°. The temperature of the ferrous chloride solution is set at 30 to 60°C. A decrease in the temperature of the ferrous chloride solution causes the etching rate to decrease, and an increase in the temperature of the ferrous chloride solution causes the etching rate to increase. A high temperature of the ferrous chloride solution also causes the deterioration of the solution to progress in a short time.

The degree of the deterioration of the solution can be continuously determined and evaluated by measuring the rest potential of a platinum plate immersed in the ferrous chloride solution. Simple methods for recovering the capability of the deteriorating solution include adding some more new solution to the solution and changing the entire solution with new solution. A chlorine gas may be blown into the deteriorating solution.

As for the surface roughness after etching, 3 µm or smaller in Ra value, a surface roughness index defined in JIS, suffices. When roughened, the surface improves its wettability (hydrophilic property) and comes into a surface roughness state that is suitable as a polymer electrolyte fuel cell separator.

After the etching using the ferrous chloride solution, it is necessary to force the surface to be cleaned with a large quantity of clean water, immediately. This is for washing away surface deposits (precipitates) originating from the diluted ferrous chloride solution using the cleaning water. For this reason, it is desirable to perform spray cleaning, which allows a flow velocity to be increased on the surface of the starting material. In addition, it is desirable to employ, together with the spray cleaning, cleaning in which the surface is immersed in flowing water after the spray cleaning. In the cleaning and drying process performed thereafter, various metallic chlorides and metallic hydroxides adhered on the surface turn into more stable metals, or their hydroxides or oxides in the atmosphere. For that matter, Sn and In, playing the important role in the present invention, turn into a metal Sn and a metal In, or their oxides. All of the metals and the compounds have conductivities and are present on the surface in their concentrated state, performing the function of reducing the surface contact resistance in the present invention.

### (3-6) Spray Cleaning and Immersion Treatment using Sulfuric Acid Aqueous Solution

The concentration of the sulfuric acid aqueous solution to be applied differs in accordance with the corrosion resistances of inventive steels to be treated. The concentration is adjusted to a corrosiveness of such a degree at which bubbles is observed starting to form on the surface when the separator is immersed. Such a condition of the concentration that causes bubbles to heavily form with corrosion is undesirable. However, a concentration of the sulfuric acid aqueous solution of more than 20% causes heavy corrosion of the base metal. Therefore, the upper limit of the concentration is set at less than 20%. The corrosiveness varies also depending on solution temperature. The sulfuric acid aqueous solution is supposed to be used within a range from a normal temperature to 45°C. A solution temperature of more than 60°C leads to a poor working property and an intense corrosiveness, resulting in a failure to obtain a desired surface state.

In other words, such a solution temperature hinders Sn and In, playing the important role in the present invention, from being concentrated on the surface in the form of a metal Sn and a metal In, or their oxides, which provides an insufficient function of reducing the surface contact resistance immediately after the separator is applied to a polymer electrolyte fuel cell.

The treatment may be spray pickling or may be immersion treatment in the state where the solution is flowing or settled.

### (3-7) Spray Cleaning and Immersion Treatment using Nitric Acid Solution

The concentration of the nitric acid aqueous solution to be applied differs in accordance with the corrosion resistances of stainless steels to be treated. The concentration is adjusted to a corrosiveness of such a degree at which bubbles is observed starting to form on the surface when the separator is immersed. Such a condition of the concentration that causes bubbles to heavily form with corrosion is undesirable. However, a concentration of the nitric acid aqueous solution of more than 40% causes heavy corrosion of the base metal. Therefore, the upper limit of the concentration is set at less than 40%. The corrosiveness varies also depending on solution temperature. The nitric acid aqueous solution is supposed to be used within a range from a normal temperature to 80°C. A solution temperature of more than 80°C leads to a poor working property and an intense corrosiveness, resulting in a failure to obtain a desired surface state.

In other words, such a solution temperature hinders Sn and In, playing the important role in the present invention, from being concentrated on the surface in the form of a metal Sn and a metal In, or their oxides, which provides an insufficient function of reducing the surface contact resistance immediately after the separator is applied to a polymer electrolyte fuel cell.

The treatment may be spray pickling or may be immersion treatment in the state where the solution is flowing or settled.

### (3-8) Sputtering Target Material

The surface modification treatment is performed using a target material for sputtering mainly constituted by a metal In and a metal Sn, or their oxides. A target easily available on the market is a sputtering target for ITO film formation, which is made up of In oxides and Sn oxides. Normally, the In oxides account for 90%, and the Sn oxides account for about 10%. Such a sputtering target is also applicable to the present invention.

It should be noted that the present invention allows the amount of In in the sputtering target material to be reduced. In is a very expensive metallic element, and its oxides are also very expensive. When the In oxides account for 10% and the Sn oxides account for 90%, they suffice. The other metallic elements are allowed to be present but preferably small in amount because they lead to performance degradation. Considering the amount of In and the amount of Sn in the sputtering target material, use is made, as the target material, of an alloy containing In and Sn at a composition ratio of 95% by mass or more in terms of In mass% + Sn mass%, the composition ratio being of only metallic elements, excluding oxygen.

Next, the effects of the present invention will be described specifically in conjunction with examples.

### EXAMPLE

### Example 1

Steel materials 1 to 17 having the chemical compositions shown in Table 1 were melted in a 180-kg vacuum furnace and made into flat ingots each having a maximum thickness of 80 mm. The steel material 17 is equivalent to SUS316L, a commercially available austenitic stainless steel. The steel materials 1 to 12 are example embodiments of the present invention, and the steel materials 13 to 17 are comparative examples. In Table 1, each underline indicates that an underlined value falls out of the range defined in the present invention, REM represents a misch metal (rare earth metals), and Index (mass %) values are values of (Cr mass % + 3 × Mo mass %).

**[Table 1**

| | Steel material | C | Si | Mn | P | S | Cr | Mo | Ni | Cu | N | V | Sn | In | Al | Ti, Nb | REM | Index |
|---|---|---|---|---|---|---|---|---|---|---|---|---|---|---|---|---|---|---|
| 1 | Inventive Example | 0.002 | 0.15 | 0.08 | 0.022 | 0.001 | 26.0 | 0.08 | 0.08 | 0.07 | 0.003 | 0.08 | 0.15 | 0.28 | 0.030 | 0.12Nb | - | 26.2 |
| 2 | Inventive Example | 0.002 | 0.16 | 0.08 | 0.021 | 0.001 | 26.1 | 2.01 | 0.06 | 0.06 | 0.004 | 0.08 | 0.20 | 0.08 | 0.030 | 0.10Nb | - | 32.1 |
| 3 | Inventive Example | 0.003 | 0.15 | 0.10 | 0.022 | 0.001 | 26.3 | 2.02 | 0.06 | 0.06 | 0.003 | 0.08 | 0.21 | 0.15 | 0.040 | 0.12Nb | - | 32.4 |
| 4 | Inventive Example | 0.002 | 0.16 | 0.09 | 0.022 | 0.001 | 26.2 | 2.01 | 0.06 | 0.06 | 0.003 | 0.08 | 0.20 | 0.21 | 0.030 | 0.12Nb | - | 32.2 |
| 5 | Inventive Example | 0.004 | 0.16 | 0.08 | 0.023 | 0.001 | 26.3 | 2.02 | 0.08 | 0.07 | 0.005 | 0.08 | 0.45 | 0.25 | 0.030 | 0.11Nb | - | 32.4 |
| 6 | Inventive Example | 0.004 | 0.22 | 0.16 | 0.026 | 0.001 | 28.2 | 2.21 | 0.16 | 0.12 | 0.006 | 0.08 | 0.15 | 0.10 | 0.040 | 0.11Ti | - | 34.8 |
| 7 | Inventive Example | 0.003 | 0.22 | 0.18 | 0.025 | 0.001 | 28.0 | 2.19 | 0.15 | 0.10 | 0.007 | 0.09 | 0.21 | 0.20 | 0.030 | 0.12Ti | - | 34.6 |
| 8 | Inventive Example | 0.004 | 0.21 | 0.18 | 0.025 | 0.001 | 28.2 | 2.18 | 0.16 | 0.11 | 0.006 | 0.09 | 0.45 | 0.21 | 0.030 | 0.12Ti | - | 34.7 |
| 9 | Inventive Example | 0.003 | 0.42 | 0.35 | 0.026 | 0.001 | 28.3 | 2.20 | 0.16 | 0.10 | 0.005 | 0.09 | 0.62 | 0.20 | 0.040 | 0.12Ti | | 34.9 |
| 10 | Inventive Example | 0.002 | 0.41 | 0.32 | 0.028 | 0.001 | 28.2 | 4.03 | 0.15 | 0.12 | 0.007 | 0.08 | 0.21 | 0.20 | 0.030 | - | 0.018 | 40.3 |
| 11 | Inventive Example | 0.002 | 0.42 | 0.35 | 0.025 | 0.001 | 28.1 | 4.01 | 2.21 | 0.14 | 0.008 | 0.08 | 0.45 | 0.22 | 0.030 | - | - | 40.1 |
| 12 | Inventive Example | 0.011 | 0.55 | 0.50 | 0.033 | 0.008 | 32.1 | 2.20 | 0.09 | 0.56 | 0.012 | 0.10 | 0.80 | 0.28 | 0.035 | 0.08Ti 0.12Nb | 0.018 | 36.7 |
| 13 | Comparative example | 0.003 | 0.25 | 0.31 | 0.026 | 0.001 | 18.8 | 0.002 | 0.08 | 0.03 | 0.004 | 0.05 | 0.002 | 0.0001 | 0.010 | 0.23Nb | - | 18.8 |
| 14 | Comparative example | 0.003 | 0.25 | 0.15 | 0.022 | 0.001 | 26.0 | 2.08 | 0.09 | 0.03 | 0.004 | 0.08 | 0.001 | 0.0001 | 0.080 | 0.21Nb | - | 32.2 |
| 15 | Comparative example | 0.003 | 0.26 | 0.16 | 0.021 | 0.001 | 26.1 | 2.03 | 0.11 | 0.03 | 0.004 | 0.06 | 0.08 | 0.0001 | 0.080 | 0.22Nb | - | 32.2 |
| 16 | Comparative example | 0.005 | 0.25 | 0.15 | 0.022 | 0.001 | 28.2 | 2.02 | 0.10 | 0.04 | 0.005 | 0.08 | 0.08 | 0.0008 | 0.080 | 0.20Ti | - | 32.3 |
| 17 | Comparative example | 0.021 | 0.51 | 0.81 | 0.018 | 0.003 | 17.88 | 2.21 | 7.88 | 0.34 | 0.145 | 0.12 | 0.002 | 0.0001 | 0.007 | - | - | 24.5 |

| | | | | | | | | | | | | | | | | | | |
|---|---|---|---|---|---|---|---|---|---|---|---|---|---|---|---|---|---|---|
| (Note) the mark "*" indicates that the evaluation result of the starting material surface fell out of the range defined in the present invention. | | | | | | | | | | | | | | | | | | |

The casting surface of each ingot was removed by machinework. Each ingot was then heated and soaked in a city-gas burner-combustion heating furnace heated at 1180°C, and forged into a slab for hot rolling having a thickness of 60 mm and a width of 430 mm, with the surface temperature of the ingot being within a temperature range from 1160°C to 870°C. From the slab having a thickness 60 mm and a width of 430 mm, a surface defect was ground to be removed as hot processing, with the surface temperature of the slab kept at 300°C or higher. Thereafter, the slab was loaded into a city-gas heating furnace heated at 1130°C, then heated, and soaked for two hours.

Thereafter, the slab was subjected to hot rolling by a 4-high hot rolling mill to have a thickness of 2.2 mm, wound into a coil shape, and left to be cooled down to a room temperature. When the hot-rolled slab was wound into a coil shape, forced water cooling was performed by water spraying. At the time of being wound, the surface temperature of the starting material was 400°C or lower.

The hot rolled coil material was subjected to annealing at 1060°C for 150 seconds in a continuous coil annealing line, and cooled by forced air cooling. Thereafter, the hot rolled coil material was subjected to surface oxide scale removing with shot, was further descaled by being immersed in a nitric-hydrofluoric acid solution containing 8% of nitric acid + 6% of hydrofluoric acid and heated to 60°C, and was made into a starting material for cold rolling.

The cold rolled starting material was subjected to slit working to have a coil width of 400 mm, and thereafter finished into a cold rolled coil having a thickness of 0.110 mm and a width of 400 mm, by a Sendzimir 20-high cold rolling mill. Final annealing was performed in a bright annealing furnace with an atmosphere containing 75 vol% H₂ and 25 vol% N2 and having a dew point adjusted to -50 to -53°C. The heating temperature in a soaking zone was 1130°C for the steel materials 17, which was austenitic, and 1030°C for all of the other steel materials.

In all of the steel materials 1 to 17, no noticeable end face crack, coil rupture, coil surface flaw, or coil perforation was observed in the present prototype process. The steel micro structure of each steel material was a ferrite single phase. Fine carbides and nitrides such as TiN and NbC, and carbo-nitrides such as TiCN were confirmed precipitating, but the precipitation of Sn intermetallic or In intermetallic compounds was not confirmed. Each steel material was cleaned after a bright annealing oxide film on the surface of the steel material was removed by polishing with 600-grit wet emery paper, and was subjected to intergranular corrosion resistance evaluation by the copper sulfate-sulfuric acid test according to JIS-G-0575. No crack occurred in the steel materials 1 to 17 even after guided 180°C bend test. Therefore, it was determined that the steel materials 1 to 17 do not cause intergranular corrosion to occur even when applied in a fuel cell environment.

From the steel materials 1 to 17 shown in Table 1, cutlength sheets each having a thickness of 0.110 mm, a width of 400 mm, and a length of 300 mm were taken and referred to as starting materials I.

Each starting material I was subjected to the spray etching using a ferrous chloride solution at 35°C and 43° Baume in such a manner that the treatment was simultaneously performed on the entire upper and lower surfaces of the cutlength sheet. The etching was performed by spraying for a time period of about 40 seconds. The spraying time period was adjusted by strip running speed. An amount of scarfing was set at 5 µm for each side. Immediately after the spray etching, spray cleaning using clean water, immersion cleaning in clean water, and drying treatment using an oven were successively performed. After the drying treatment, a 60 mm square sample was cut out from each starting material I and referred to as a starting material II.

In addition, each starting material I was subjected to the spray etching using the ferrous chloride solution, immediately followed by the spray cleaning using clean water and the immersion cleaning in cleaning water. Thereafter, the starting material I was uninterruptedly subjected to the spray cleaning using 5% sulfuric acid aqueous solution at a solution temperature of 28°C, followed by the spray cleaning using clean water and further followed by the immersion cleaning, successively without performing the drying treatment, and was referred to as a starting material III. The temperature of the sulfuric acid aqueous solution was 28°C, and the temperature of the cleaning water was 18°C.

In addition, each starting material I was subjected to the spray etching using the ferrous chloride solution, immediately followed by the spray cleaning using clean water and the immersion cleaning in cleaning water. Thereafter, the starting material I was uninterruptedly subjected to the spray cleaning using 10% nitric acid aqueous solution at a solution temperature of 28°C, followed by the spray cleaning using clean water and further followed by the immersion cleaning, successively without performing the drying treatment, and was referred to as a starting material IV. The temperature of the nitric acid aqueous solution was 28°C, and the temperature of the cleaning water was 18°C.

From the starting materials II, III, and IV, 15 cm square cutlength sheets were taken, fixed to a fixing jig for sputtering that allows four sheets to be set at a time, and subjected to the surface modification treatment by sputtering. The fixing jig had a structure that allows attachment or detachment to or from a conveyance line in a sputtering device. As a sputtering target starting material, use was made of a commercially available target that was made by mixing indium oxide powder and tin oxide powder at a ratio of 9:1 and performing hot isostatic press (HIP) treatment. The amount of impurities in the target material was at an amount level of inevitable impurities, which was less than 0.05%. The thickness of the modified layer was intended to be 0.5 µm (constant) that was evaluated as a weight per unit area with reference to how much the modified layer would increase the weight of the starting material. It was confirmed in advance that the sputtering was able to be performed uniformly within the area of the fixing jig for sputtering. The starting materials after the treatment were referred to as starting materials IIS, IIIS, and IVS, respectively.

Now, the sputtering device used will be schematically described. The sputtering device includes a stainless-steel-made chamber that includes therein a mechanism of conveyancing a fixing holder for sputtering. Pressure reduction is performed by a vacuum pump with a mechanical booster, a diffusion pump, and a cryopump, which can easily perform a pressure reduction up to 10⁻⁵ mmHg.

The treatment device has a width of 1.6 m and an overall length of 19 m in appearance, and includes five chambers: a pressure reducing chamber, a preparation chamber, a surface modification treatment chamber 1, a surface modification treatment chamber 2, and a pressure recovering chamber, from the front side of the treatment device. The chambers are contiguous but separated by movable partition gates and complies with specifications in which air does not enter the preparation chamber, the surface modification treatment chamber 1, and the surface modification treatment chamber 2 even when the pressure reducing chamber or the pressure recovering chamber are opened to the air for carrying-in or carrying-out the holder, and a degree of vacuum is controllable within a range not exceeding 5 × 10⁻³ mmHg.

Each chamber can be individually controlled in terms of degree of vacuum and atmosphere. In each of the surface modification treatment chambers 1 and 2, two sputtering zones are provided in a direction of progress, which facilitates multi-layering of different substances by changing a sputtering target with a desired target, or facilitate increasing a thickness of the same composition.

In addition, it is possible to perform nitriding treatment, carbide treatment, or the like by introducing a trace quantity of a nitrogen gas, an acetylene gas, or the like under a reduced pressure, as necessary. The sputtering can be performed uniformly up to a width of 600 mm. An excitation frequency is 13.56 MHz, which is of a standard, and the treatment device also has the capability of sputtering by HIPIMS. In the sputtering, a reference bias voltage applied to a substrate was set at -100 V (constant), and the setting is changed as appropriate and as necessary.

With this equipment, a structure of four or more layers of different substances can be located by causing a fixing holder for sputtering once moving forward to move backward and move forward again. The thickness of the film is controlled with a sputtering rate, a strip running speed, and a sputtering zone residence time. The holder fixing base for sputtering can rotate in the device while moving forward. The sputtering is performed while causing the holder to rotate as necessary. This improves the quality of the surface layer.

In the preparation chamber, preheating equipment is installed that allows the substrate to be preheated, toward 250°C, by radiant heat of heat generator energized and heated from a rear side of the holder while fixed in the holder, before conveyed to the surface modification treatment chamber 1. The temperature of the starting material in the middle of the sputtering is measured on the rear side of the starting material, but temperature control by water cooling is not performed. The temperature of the substrate is adjusted not to exceed 400°C, under the sputtering conditions.

A decrease in the temperature of the substrate in the treatment chamber is very slow because the atmosphere is in a pressure-reduced and vacuum state. The pressure reducing chamber and the pressure recovering chamber each have a structure that allows holders to be carried in or out at a time up to 30, and the holders can be carried out or in a sequential and single-sheet manner. Opening or closing the pressure reducing chamber and the pressure recovering chamber to or from the air is performed batchwise. Meanwhile, conveyance under a reduced pressure from the preparation chamber to the surface modification treatment chamber 2 is performed in a sequential manner, and a conveyance speed can be set for each chamber individually.

In the polymer electrolyte fuel cell, the outermost surface of the starting material alters in accordance with the in-cell environment. For the purpose of simulating the surface alteration in the cell, the starting materials were subjected to immersion treatment using a sulfuric acid aqueous solution simulating the in-fuel-cell environment, containing 100 ppm F-ion, and having a pH of 4, at 90°C for 500 hours. The starting materials for simulating the fuel cell application were referred to as starting materials IISm, IIISm, and IVSm.

The measurement of an electric surface contact resistance was performed while a starting material for evaluation is sandwiched by carbon paper TGP-H-90 from Toray Industries, Inc. that is sandwiched between platinum plates. The method for the measurement is a four-terminal method, which is generally used in the evaluation of a separator for fuel cells. An applied load in the measurement was set at 10 kgf/cm² (constant). A lower measured value means a smaller IR loss in generating electric power as well as a smaller energy loss in heat generation, which can be determined to be favorable. The carbon paper TGP-H-90 from Toray Industries, Inc. was changed every measurement.

Table 2 collectively shows the electric contact resistance values of the starting materials I, II, IIS, and IISm, and the amounts of iron ions that were dissolved in the sulfuric acid aqueous solution for the in-cell environment simulation containing 100 ppm F-ion and having a pH of 4 when the starting materials I, II, IIS, and IISm were immersed in the sulfuric acid aqueous solution for 500 hours. In the measurement of metal ion dissolution, Cr ions, Mo ions, Sn ions, In ions, and the like are determined at the same time, but the amounts thereof were very small. Therefore, the amounts are shown as the corrosion behavior of a starting material expressed in terms of an amount of Fe ions, which are the largest amount of dissolution and have a significant influence on the fuel cell performance. The number of starting material tests was two for all starting materials.

**[Table 2]**

| Steel material | | Electric surface contact resistance (mΩ·cm²): applied load was 10kgf/cm² | | | | Iron ion concentration (ppb) In-cell environment simulation in starting material IISm treatment 100 ppm F-containing pH 4 sulfuric acid aqueous solution, 90°C, teflon holder put obliquely, in immersion solution after 500 hrs immersion: two 60 mm square specimens immersed, solution volume, 800 ml |
|---|---|---|---|---|---|---|
| | | (Starting material I) before ferrous chloride solution treatment | (Starting material II) after 43° Be ferrous chloride solution treatment | (Starting material IIS) after sputtering | (Starting material IISm) in-fuel-cell environment simulation 100 ppm F-containing pH 4 sulfuric acid aqueous solution, 90°C, teflon holder put obliquely, after 500 hrs immersion | |
| 1 | Inventive Example | >2000* | 15,16 | 2,2 | 2,3 | 24 |
| 2 | Inventive Example | >2000* | 13,15 | 2,2 | 2,2 | 23 |
| 3 | Inventive Example | >2000* | 13,13 | 2,2 | 2,3 | 24 |
| 4 | Inventive Example | >2000* | 12,14 | 2,2 | 2,2 | 25 |
| 5 | Inventive Example | >2000* | 10,11 | 2,2 | 2,2 | 24 |
| 6 | Inventive Example | >2000* | 14,16 | 2,2 | 2,2 | 30 |
| 7 | Inventive Example | >2000* | 12,13 | 2,2 | 2,3 | 28 |
| 8 | Inventive Example | >2000* | 12,12 | 2,2 | 2,2 | 26 |
| 9 | Inventive Example | >2000* | 12,12 | 2,2 | 2,2 | 24 |
| 10 | Inventive Example | >2000* | 12,13 | 2,2 | 2,3 | 26 |
| 11 | Inventive Example | >2000* | 11,11 | 2,2 | 2,2 | 24 |
| 12 | Inventive Example | >2000* | 11,12 | 2,2 | 2,2 | 23 |
| 13 | Comparative example | >2000* | 89,96* | 2,2* | 7,13* | 43* |
| 14 | Comparative example | >2000* | 73,78* | 2,2* | 12,16* | 51* |
| 15 | Comparative example | >2000* | 66,68* | 2,2* | 8,14* | 48* |
| 16 | Comparative example | >2000* | 54,55* | 2,2* | 6,18* | 46* |
| 17 | Comparative example | >2000* | 52,55* | 2,2* | 11,16* | 53* |
| 18 | Comparative example Gold-plated product | - | 2,2* | | 2,2* | 31* |

| | | | | | | |
|---|---|---|---|---|---|---|
| (Note) the mark "*" indicates that the evaluation result of the starting material surface fell out of the range defined in the present invention. | | | | | | |

As for the starting materials I for measurement, the surface contact resistance values were as very high as 2000 mΩ because a high-temperature oxide film generated in final bright annealing was present on the surface of each starting material. High-temperature oxides in the coating film mainly include Si oxides, Fe oxides, and Cr oxides. The composition and thickness of a high-temperature oxide film fall under a significant influence of the in-furnace state in bright annealing. The thickness is normally about several hundreds of angstroms. Since the starting materials I had excessively high energized resistance values, it is difficult to apply the starting materials I as separators for polymer electrolyte fuel cells as they are.

The surface contact resistance values of the starting materials II, which were obtained by subjecting the starting materials I to the spray etching using the ferrous chloride solution, were remarkably reduced both in example embodiments of the present invention and comparative examples. This is largely attributable to an effect of dissolution, detachment, and falling off of the high-temperature oxide film on the surface by the spray etching using the ferrous chloride solution. This is also attributable to an effect of an unevenness shape of the surface.

The surface after the ferrous chloride solution treatment is covered with only an oxide surface coating film mainly containing hydroxides generated in the air. The thickness of the oxide surface coating film is from several nm to about 20 nm. The necessary condition for applying a starting material as a separator for polymer electrolyte fuel cells is determined as a surface contact resistance of the starting material being several tens mΩ or lower, desirably less than 10 mQ in a stable state, or 30 mΩ or lower at the most. All of the comparative examples are problematic for the application.

The contact resistance values of the surfaces of the starting materials IIS, which were obtained by subjecting the starting materials II to the sputtering, were stably low in comparison with the surfaces of the starting materials II independent of the component of the substrate, being contact resistance values almost equal to that of a starting material 18, a gold-plated surface considered to be ideal. One of the advantages of the surface modification treatment is that obtained performance is derived from the performance of the modified surface layer, independent of the component of the substrate.

The contact resistances of the surfaces of the starting materials IISm, which were obtained by subjecting the surfaces of the starting materials IIS to the immersion treatment using the sulfuric acid aqueous solution environment that simulates the in-cell environment, were sufficiently low, while some Examples show slightly high contact resistance values in comparison with those of the surfaces of the starting materials IIS depending on the components of the starting materials. It is determined that this is attributable to a film defect that inevitably resides on a surface-modification-treated surface. From a defect portion, corrosion and falling off of the surface modified film can occur, and from a micro defective portion, the dissolution of the substrate and the deposition of corrosion products can occur. However, the starting materials IISm can be confirmed to have contact resistance performances that are clearly improved in comparison with those of the surfaces of the starting materials II not subjected to the sputtering.

Table 3 collectively shows the electric contact resistance values of the starting materials II, III, IIIS, and IIISm, and the amounts of iron ions that were dissolved in the sulfuric acid aqueous solution for the in-cell environment simulation containing 100 ppm F-ion and having a pH of 4 when the starting materials II, III, IIIS, and IIISm were immersed in the sulfuric acid aqueous solution for 500 hours.

**[Table 3]**

| Steel material | | Electric surface contact resistance (mΩ·cm²): applied load was 10kgf/cm² | | | | Iron ion concentration (ppb) In-cell environment simulation in treatment of starting material IIISm for measurement 100 ppm F-containing pH 4 sulfuric acid aqueous solution, 90°C, teflon holder put obliquely, in immersion solution after 500 hrs immersion: two 60 mm square specimens immersed, solution volume 800 ml measurement |
|---|---|---|---|---|---|---|
| | | (Starting material II) after 43° Be ferrous chloride solution treatment | Measurement starting material III 10% sulfuric acid aqueous solution treatment before drying starting material I for measurement | Starting material for measurement IIIS: sputtering | Starting material IIISm for In-fuel-cell environment simulation 100 ppm F-containing pH sulfuric acid aqueous solution 90°C, teflon holder put obliquely, 500 hrs immersion | |
| 1 | Inventive Example | 15,16 | 7,8 | 2,2 | 2,2 | 23 |
| 2 | Inventive Example | 13,15 | 7,8 | 2,2 | 2,2 | 21 |
| 3 | Inventive Example | 13,13 | 6,7 | 2,2 | 2,2 | 21 |
| 4 | Inventive Example | 12,14 | 6,6 | 2,2 | 2,2 | 21 |
| 5 | Inventive Example | 10,11 | 3,4 | 2,2 | 2,2 | 22 |
| 6 | Inventive Example | 14,16 | 6,7 | 2,2 | 2,2 | 21 |
| 7 | Inventive Example | 12,13 | 6,7 | 2,2 | 2,3 | 22 |
| 8 | Inventive Example | 12,12 | 5,6 | 2,2 | 2,2 | 21 |
| 9 | Inventive Example | 12,12 | 4,5 | 2,2 | 2,2 | 21 |
| 10 | Inventive Example | 12,13 | 6,7 | 2,2 | 2,2 | 22 |
| 11 | Inventive Example | 11,11 | 4,4 | 2,2 | 2,2 | 22 |
| 12 | Inventive Example | 11,12 | 6,7 | 2,2 | 2,2 | 23 |
| 13 | Comparative example | 89,96* | 73,84* | 2,2* | 8,12* | 46* |
| 14 | Comparative example | 73,78* | 68,68* | 2,2* | 14,17* | 55* |
| 15 | Comparative example | 66,68* | 62,61* | 2,2* | 10,18* | 46* |
| 16 | Comparative example | 54,55* | 45,46* | 2,2* | 9,15* | 48* |
| 17 | Comparative example | 52,55* | 41,46* | 2,2* | 12,17* | 51* |
| 18 | Comparative example Gold plated | 2,2* | | | 2,2* | 31* |

| | | | | | | |
|---|---|---|---|---|---|---|
| (Note) the mark "*" indicates that the evaluation result of the starting material surface fell out of the range defined in the present invention. | | | | | | |

It can be confirmed that the behaviors shown in table 3 are similar to the behaviors of the starting materials II, IIS, and IISm shown in Table 2. Relatively, the contact resistance values are stabilized and further decrease. It is determined that the spray pickling treatment or the acid solution immersion treatment using the sulfuric acid aqueous solution performed before the sputtering generates hydroxides or oxides of Sn and In thinly on the surface of the substrate, which brought about the favorable results.

In the sputtering, the surface is subjected to ion bombardment treatment. As for these prototypes, it is determined that Sn- and In oxides still resided on the outermost layers, which have an effect on curbing performance degradation after the sputtering, in particular, performance degradation from a defect in the surface-modification-treated film in the application to an actual fuel cell.

Table 4 collectively shows the electric contact resistance values of the starting materials II, IV, IVS, IVSm, and the amounts of iron ions that were dissolved in the sulfuric acid aqueous solution for the in-cell environment simulation containing 100 ppm F-ion and having a pH of 4 when the starting materials II, IV, IVS, IVSm were immersed in the sulfuric acid aqueous solution for 500 hours.

**[Table 4]**

| Steel material | | Electric surface contact resistance (mΩ·cm²): applied load was 10kgf/cm² | | | | Iron ion concentration (ppb) In-cell environment simulation in starting material IVSm treatment 100 ppm F-containing pH 4 sulfuric acid aqueous solution, 90°C, teflon holder put obliquely, in immersion solution after 500 hrs immersion: two 60 mm square specimens immersed, solution volume 800 ml |
|---|---|---|---|---|---|---|
| | | (Starting material II) after 43° Be ferrous chloride solution treatment | (Starting material IV) 30% nitric acid aqueous solution treatment before drying starting material I for measurement | (Starting material IVS): sputtering | Starting material IVSm for measurement In-cell environment simulation 100 ppm F-containing pH 4 sulfuric acid aqueous solution, 90°C, teflon holder put obliquely, 500 hrs immersion | |
| 1 | Inventive Example | 15,16 | 8,8 | 2,2 | 2,2 | 22 |
| 2 | Inventive Example | 13,15 | 8,9 | 2,2 | 2,2 | 21 |
| 3 | Inventive Example | 13,13 | 7,8 | 2,2 | 2,2 | 21 |
| 4 | Inventive Example | 12,14 | 7,7 | 2,2 | 2,2 | 21 |
| 5 | Inventive Example | 10,11 | 3,4 | 2,2 | 2,2 | 21 |
| 6 | Inventive Example | 14,16 | 6,6 | 2,2 | 2,2 | 21 |
| 7 | Inventive Example | 12,13 | 7,7 | 2,2 | 2,3 | 21 |
| 8 | Inventive Example | 12,12 | 6,7 | 2,2 | 2,2 | 21 |
| 9 | Inventive Example | 12,12 | 5,6 | 2,2 | 2,2 | 21 |
| 10 | Inventive Example | 12,13 | 7,7 | 2,2 | 2,2 | 22 |
| 11 | Inventive Example | 11,11 | 4,5 | 2,2 | 2,2 | 23 |
| 12 | Inventive Example | 11,12 | 7,7 | 2,2 | 2,2 | 22 |
| 13 | Comparative example | 89,96* | 102,104* | 2,2* | 12,13* | 52* |
| 14 | Comparative example | 73,78* | 108,109* | 2,2* | 13,15* | 61* |
| 15 | Comparative example | 66,68* | 103,104* | 2,2* | 12,16* | 52* |
| 16 | Comparative example | 54,55* | 103,103* | 2,2* | 11,14* | 57* |
| 17 | Comparative example | 52,55* | 126,124* | 2,2* | 12,16* | 53* |
| 18 | Comparative example Gold plated | 2,2* | | | 2,2* | 31* |

| | | | | | | |
|---|---|---|---|---|---|---|
| (Note) the mark "*" indicates that the evaluation result of the starting material surface fell out of the range defined in the present invention. | | | | | | |

It can be confirmed that the behaviors shown in table 4 are similar to the behaviors of the starting materials II, IIS, and IISm, and the starting materials III, IIIS, and IIISm shown in Tables 2 and 3. Relatively, in terms of the contact resistance performances of the starting materials IVS and IVSm, in particular, the starting material IVSm, the contact resistance values are stabilized and low. It is determined that the treatment using the nitric acid aqueous solution generated no sulfate (called sulfuric acid smut) that resided on the surface of the starting material III.

It is determined that, similarly to the starting materials II and III, the spray pickling treatment or the acid solution immersion treatment using the nitric acid aqueous solution performed before the sputtering generates hydroxides or oxides of Sn and In thinly on the surface of the substrate, which exerts the favorable results.

In the sputtering, the surface is subjected to ion bombardment treatment. It is determined that Sn- and In oxides resided on the outermost layers, which curbed performance degradation after the sputtering, in particular, performance degradation from a defect in the surface-modification-treated film in the application to an actual fuel cell.

The effect of adding Sn and In is obvious in the example embodiments of the present invention 1 to 12 each of which includes the substrate containing Sn and In, in comparison with the comparative examples 13 to 17 each of which contains no Sn nor In.

In the example embodiments of the present invention 1 to 12, the concentrations of iron ion dissolved in the immersion test in the 100 ppm F-containing pH 4 sulfuric acid aqueous solution using the starting materials IISm, IIISm, and IVSm were generally low. It is determined that application of any one of the example embodiments of the present invention 1 to 12 as a polymer electrolyte fuel cell separator poses no risk of resulting in performance degradation of the cell such as MEA film contamination.

The excellent performances confirmed with the comparative steel 18 in Table 2, Table 3, and Table 4 were naturally due to a surface cover effect by gold plating, which is expensive and excellent in corrosion resistance.

### Example 2

As described in Example 1, performing the surface modification treatment shows a significant performance effect of improvement independent of the component of the substrate, by virtue of the remarkable effect of improving the surface contact resistance performance of the surface modified layer. Some typical treatment examples were selected from the examples and comparative examples shown in Tables 2 to 4, separators having a shape illustrated by a picture in Figure 2 were produced by press forming, and then performance evaluation was performed using an actual fuel cell. Table 5 collectively shows the results.

**[Table 5]**

| Steel material | | Surface adjustment method before surface modification treatment Parenthesized values is acid concentration % | Sputtering target composition | Cell resistance value (mΩ) behavior in single-cell fuel cell operation: constant-current operation at 0.1 mA/cm², gas usage rate: 40% 1000 hrs from operation start | Concentration of Fe ion in cathode electrode outlet gas condensate in fuel cell stack (ppb) | Concentration of Fe ion in anode-electrode-side outlet gas condensate in fuel cell stack (ppb) | Concentration of Fe ion in MEA polymer film after operation end (µg/100 cm ²) |
|---|---|---|---|---|---|---|---|
| | | | Ratio of In oxide / Sn oxide | | | | |
| 5 | Inventive Example | IIS (non-treated) | 9/1 | 0.732 | 2.0 | 2.3 | 23 |
| 5 | Inventive Example | IIIS (sulfuric acid 10) | 9/1 | 0.727 | 2.2 | 2.1 | 23 |
| 5 | Inventive Example | IVS (nitric acid 30) | 9/1 | 0.743 | 2.0 | 2.2 | 21 |
| 8 | Inventive Example | IIS (non-treated) | 8/2 | 0.735 | 2.1 | 2.0 | 23 |
| 8 | Inventive Example | IIIS (sulfuric acid 10) | 8/2 | 0.728 | 2.1 | 2.3 | 22 |
| 8 | Inventive Example | IVS (nitric acid 30) | 8/2 | 0.748 | 2.0 | 2.2 | 21 |
| 11 | Inventive Example | IIS (non-treated) | 3/7 | 0.731 | 2.0 | 2.2 | 22 |
| 11 | Inventive Example | IIIS (sulfuric acid 10) | 3/7 | 0.728 | 2.0 | 2.1 | 20 |
| 11 | Inventive Example | IVS (nitric acid 30) | 3/7 | 0.742 | 2.0 | 2.2 | 22 |
| 5 | Comparative example | II | -(Not conducted)* | 0.872* | 19.3* | 159* | 151* |
| 5 | Comparative example | III | -(Not conducted)* | 0.898* | 13.9* | 103* | 149* |
| 5 | Comparative example | IV | -(Not conducted)* | 0.864* | 14.6* | 101* | 143* |
| 14 | Comparative example | IIS (non-treated) | 9/1 | 0.829* | 12.2* | 23* | 66* |
| 14 | Comparative example | IIIS (sulfuric acid 10) | 9/1 | 0.857* | 11.2* | 21* | 62* |
| 14 | Comparative example | IVS (nitric acid 30) | 9/1 | 0.846* | 12.6* | 22* | 68* |
| 18 | Comparative example | Gold plated | | 0.762* | 2.3* | 22* | 64* |

| | | | | | | | |
|---|---|---|---|---|---|---|---|
| (Note) the mark "*" indicates that the evaluation result of the starting material surface fell out of the range defined in the present invention. | | | | | | | |

The channel was in a serpentine shape as illustrated in Figure 2. The area of a channel portion through which reactant gas flows was 100 cm².

The condition specified for evaluating fuel cell operation was constant-current operation evaluation at a current density of 0.1 A/cm². The operation evaluation environment of residential fuel cell use was simulated. A hydrogen-oxygen utilization was set to be constant at 40%. The time period of the evaluation was 1000 hours.

The electric cell resistance value of the cell in operating was measured with a commercially available resistance meter from Tsuruga Electric Corporation (MODEL3565). In terms of alternating-current impedance value at a frequency of 1 KHz, the measured cell resistance value was comparable to that of the steel materials 18, which was determined to be the most excellent cell resistance value. In the inventive examples, it can be confirmed that providing the surface modified layer enables a very excellent performance to be secured without using noble metals, which are expensive.

### Example 3

The performance evaluation in an actual fuel cell was performed on polymer electrolyte fuel cell separators that were subjected to the surface modification treatment by the treatment method for the starting materials IIS, IIIS, and IVS in the same manner as in Example 2, and thereafter subjected to the spray treatment or the immersion treatment using the sulfuric acid aqueous solution or the nitric acid aqueous solution. Table 6 collectively shows the results.

In the examples shown in Table 6, the component analysis was conducted on the surface modified layers of all the starting materials. The oxygen concentrations in the surface modified layers were 14 to 28%, less than 30%.

**[Table 6]**

| Steel material | | Surface adjustment method before surface modification treatment Parenthesized values is acid concentration % | Sputtering target composition Ratio of In oxide / Sn oxide | Surface adjustment method using acid aqueous solution after surface modification treatment Numeric value is acid concentration % | Cell resistance value (mΩ) in single-cell fuel cell operation: constant-current operation at 0.1 mA/cm², gas usage rate: 40% 1500 hrs from operation start | Concentration of Fe ion in cathode electrode outlet gas condensate in fuel cell stack (ppb) | Concentration of Fe ion in anode-electrode-side outlet gas condensate in fuel cell stack (ppb) | Concentration of Fe ion in MEA polymer film after operation end (µg/100 cm²) |
|---|---|---|---|---|---|---|---|---|
| 5 | Inventive Example | IIS (non-treated) | 9/1 | Sulfuric acid 10 | 0.758 | 2.0 | 2.1 | 21 |
| 5 | Inventive Example | IIS (non-treated) | 9/1 | Nitric acid 30 | 0.756 | 2.1 | 2.0 | 20 |
| 5 | Inventive Example | IIIS (sulfuric acid 10) | 9/1 | Sulfuric acid 10 | 0.737 | 2.0 | 2.1 | 21 |
| 5 | Inventive Example | IIIS (sulfuric acid 10) | 9/1 | Nitric acid 30 | 0.736 | 2.0 | 2.0 | 19 |
| 5 | Inventive Example | IVS (nitric acid 30) | 9/1 | Sulfuric acid 10 | 0.742 | 2.0 | 2.0 | 21 |
| 5 | Inventive Example | IVS (nitric acid 30) | 9/1 | Nitric acid 30 | 0.747 | 2.1 | 2.1 | 19 |
| 8 | Inventive Example | IIS (non-treated) | 8/2 | Sulfuric acid 10 | 0.759 | 2.1 | 2.0 | 20 |
| 8 | Inventive Example | IIS (non-treated) | 8/2 | Nitric acid 30 | 0.755 | 2.0 | 2.0 | 20 |
| 8 | Inventive Example | IIIS (sulfuric acid 10) | 8/2 | Sulfuric acid 10 | 0.739 | 2.0 | 2.1 | 20 |
| 8 | Inventive Example | IIIS (sulfuric acid 10) | 8/2 | Nitric acid 30 | 0.730 | 2.1 | 2.0 | 22 |
| 8 | Inventive Example | IVS (nitric acid 30) | 8/2 | Sulfuric acid 10 | 0.746 | 2.1 | 2.0 | 21 |
| 8 | Inventive Example | IVS (nitric acid 30) | 8/2 | Nitric acid 30 | 0.748 | 2.0 | 2.1 | 20 |
| 11 | Inventive Example | IIS (non-treated) | 3/7 | Sulfuric acid 10 | 0.759 | 2.0 | 2.0 | 21 |
| 11 | Inventive Example | IIS (non-treated) | 3/7 | Nitric acid 30 | 0.756 | 2.0 | 2.0 | 20 |
| 11 | Inventive Example | IIIS (sulfuric acid 10) | 3/7 | Sulfuric acid 10 | 0.738 | 2.1 | 2.1 | 20 |
| 11 | Inventive Example | IIIS (sulfuric acid 10) | 3/7 | Nitric acid 30 | 0.737 | 2.0 | 2.0 | 20 |
| 11 | Inventive Example | IVS (nitric acid 30) | 3/7 | Sulfuric acid 10 | 0.748 | 2.0 | 2.1 | 21 |
| 11 | Inventive Example | IVS (nitric acid 30) | 3/7 | Nitric acid 30 | 0.740 | 2.1 | 2.1 | 20 |
| 17 | Comparative example | Gold plated | | | 0.762 | 2.3 | 22 | 64 |

All the examples confirmed the performances that were substantially equal to or more excellent than in the case where the sulfuric acid aqueous solution treatment or the nitric acid aqueous solution treatment is performed before the surface modification treatment. It is determined that the method in Example 3 is an effective treatment method from the viewpoint of performance guarantee of final products as fuel cell separators.

In the present invention, as a standard method, preheating and ion bombardment treatment using argon gas plasma ion are performed in the preparation chamber of the sputtering device before the surface modification treatment. However, under some ion bombardment conditions, the outermost layer containing Sn and In provided in the treatment in the previous process may be removed. By not performing the ion bombardment treatment at all or performing the ion bombardment treatment only in a short time period, it is possible to avoid the removal of much of the outermost layer containing Sn and In provided in the treatment in the previous process. However, performing the sulfuric acid aqueous solution treatment or the nitric acid aqueous solution treatment after the surface modification treatment enables the reduction of the performance degradation by the ion bombardment treatment. It should be noted that the surface modified layer formed on the surface may be dissolved to be lost under some condition of the sulfuric acid aqueous solution treatment or the nitric acid aqueous solution treatment. Table 6 shows merely an example of the result of evaluation of the example embodiments of the present invention. There is the possibility that more excellent performances can be obtained under some acid solution condition, acid solution spraying condition, and acid solution immersion condition to be applied. The present invention is assumed to include the possibility.

### REFERENCE SIGNS LIST

- 1: fuel cell
- 2: polymer electrolyte membrane
- 3: fuel electrode layer (anode)
- 4: oxidant electrode layer(cathode)
- 5a, 5b: separator
- 6a, 6b: channel

## Claims

1. A separator for polymer electrolyte fuel cells having a substrate of a ferritic stainless steel, having a chemical composition comprising, in mass%:
C: 0.001 to 0.012%;
Si: 0.01 to 0.6%;
Mn: 0.01 to 0.6%;
P: 0.035% or less;
S: 0.01% or less;
Cr: 22.5 to 35.0%;
Mo: 0.01 to 4.5%;
Ni: 0.01 to 2.5%;
Cu: 0.01 to 0.6%;
Sn: 0.01 to 1.0%;
In: 0.001 to 0.30%;
N: 0.015% or less;
V: 0.01 to 0.35%;
Al: 0.001 to 0.050%;
REM: 0 to 0.1%;
Nb: 0 to 0.35%;
Ti: 0 to 0.35%; and
the balance: Fe and inevitable impurities, wherein
a calculated value of {Content of Cr (mass%) + 3 × Content of Mo (mass%)} is 22.5 to 45.0 mass%, and further comprising
a surface modified layer that has an oxygen concentration of less than 30 mass % and includes the balance containing Sn and In.

2. A method for producing a separator for polymer electrolyte fuel cells, the method comprising
forming, into a separator shape, a ferritic stainless sheet having a chemical composition including, in mass%:
C: 0.001 to 0.012%;
Si: 0.01 to 0.6%;
Mn: 0.01 to 0.6%;
P: 0.035% or less;
S: 0.01% or less;
Cr: 22.5 to 35%;
Mo: 0.01 to 4.5%;
Ni: 0.01 to 2.5%;
Cu: 0.01 to 0.6%;
Sn: 0.01 to 1.0%;
In: 0.001 to 0.30%;
N: 0.015% or less;
V: 0.01 to 0.35%;
Al: 0.001 to 0.050%;
REM: 0 to 0.1%;
Nb: 0 to 0.35%;
Ti: 0 to 0.35%; and
the balance: Fe and inevitable impurities, and
a calculated value of {Content of Cr (mass%) + 3 × Content of Mo (mass%)} is 22.5 to 45.0 mass%,
performing surface roughening by spray etching using a ferrous chloride solution at a Baume degree of 40° to 51° and a solution temperature from 30°C to 60°C,
immediately thereafter, performing rinsing and drying, and
thereafter, performing sputtering using an alloy, as a target, containing In and Sn at 95 mass% or more in total in a vacuum chamber a pressure of which is reduced to 10⁻³ mmHg or lower.

3. A method for producing a separator for polymer electrolyte fuel cells, the method comprising
forming, into a separator shape, a ferritic stainless sheet having a chemical composition comprising, in mass%:
C: 0.001 to 0.012%;
Si: 0.01 to 0.6%;
Mn: 0.01 to 0.6%;
P: 0.035% or less;
S: 0.01% or less;
Cr: 22.5 to 35.0%;
Mo: 0.01 to 4.5%;
Ni: 0.01 to 2.5%;
Cu: 0.01 to 0.6%;
Sn: 0.01 to 1.0%;
In: 0.001 to 0.30%;
N: 0.015% or less;
V: 0.01 to 0.35%;
Al: 0.001 to 0.050%;
REM: 0 to 0.1%;
Nb: 0 to 0.35%;
Ti: 0 to 0.35%; and
the balance: Fe and inevitable impurities, and
a calculated value of {Content of Cr (mass%) + 3 × Content of Mo (mass%)} is 22.5 to 45.0 mass%,
performing surface roughening by spray etching using a ferrous chloride solution at a Baume degree of 40° to 51° and a solution temperature from 30°C to 60°C,
immediately thereafter, performing rinsing,
thereafter, performing spray pickling treatment or acid solution immersion treatment using a sulfuric acid aqueous solution at a concentration of less than 20% and a temperature from a normal temperature to 60°C,
immediately thereafter, performing rinsing and drying, and
thereafter, performing sputtering using an alloy, as a target, containing In and Sn at 95 mass% or more in total in a vacuum chamber a pressure of which is reduced to 10⁻³ mmHg or lower.

4. A method for producing a separator for polymer electrolyte fuel cells, the method comprising
forming a ferritic stainless sheet having a chemical composition including, in mass%:
C: 0.001 to 0.015%;
Si: 0.01 to 0.6%;
Mn: 0.01 to 0.6%;
P: 0.035% or less;
S: 0.01% or less;
Cr: 22.5 to 35.0%;
Mo: 0.01 to 4.5%;
Ni: 0.01 to 2.5%;
Cu: 0.01 to 0.6%;
Sn: 0.01 to 1.0%;
In: 0.001 to 0.30%;
N: 0.015% or less;
V: 0.01 to 0.35%;
Al: 0.001 to 0.050%; and
the balance: Fe and inevitable impurities, and
a calculated value of {Content of Cr (mass%) + 3 × Content of Mo (mass%)} is 22.5 to 45.0 mass%, into a shape of a separator for polymer electrolyte fuel cells,
performing surface roughening by spray etching using a ferrous chloride solution at a Baume degree of 40° to 51° and a solution temperature from 30°C to 60°C,
immediately thereafter, performing rinsing,
thereafter, performing spray pickling treatment or acid solution immersion treatment using a nitric acid aqueous solution at a concentration of less than 40% and a temperature from a normal temperature to 80°C,
immediately thereafter, performing rinsing and drying, and
thereafter, performing sputtering using an alloy, as a target, containing In and Sn at 95 mass% or more in total in a vacuum chamber a pressure of which is reduced to 10⁻³ mmHg or lower.

5. The method for producing a separator for polymer electrolyte fuel cells according to any one of claim 2 to claim 4, further comprising,
after the sputtering:
performing spray pickling treatment or acid solution immersion treatment using a sulfuric acid aqueous solution at a concentration of less than 20% and a temperature from a normal temperature to 60°C; and
immediately thereafter performing rinsing and drying treatment.

6. The method for producing a separator for polymer electrolyte fuel cells according to any one of claim 2 to claim 4, further comprising,
after the sputtering:
performing spray pickling treatment or acid solution immersion treatment using a nitric acid aqueous solution at a concentration of less than 40% and a temperature from a normal temperature to 80°C; and
immediately thereafter performing rinsing and drying treatment.

7. The method for producing a separator for polymer electrolyte fuel cells according to any one of claim 2 to claim 6, wherein
the chemical composition includes
REM: 0.003 to 0.1%.

8. The method for producing a separator for polymer electrolyte fuel cells according to any one of claim 2 to claim 7, wherein
the chemical composition includes
Nb: 0.001 to 0.35 mass% and/or
Ti: 0.001 to 0.35 mass%, and
satisfies 3.0 ≤ Nb / C ≤ 25.0, 3.0 ≤ Ti / (C + N) ≤ 25.0.
